# EUROPEAN PATENT APPLICATION

(11) **EP 4 823 293 A1**
(43) Date of publication of application: **14.10.2026**
(21) Application number: 24900940.8
(22) Date of filing: 22.11.2024
(51) Int. Cl.: H10K 30/85, H10K 85/50, H10K 30/15, H10K 30/86, H10K 71/40, H10K 71/10, H10K 71/60, H10K 39/15, C23C 16/40, C23C 16/455

(54) **METHOD FOR FORMING ELECTRON TRANSFER LAYER FOR PEROVSKITE SOLAR CELL AND METHOD FOR MANUFACTURING PEROVSKITE SOLAR CELL**

(30) Priority: 04.12.2023 KR 20230173614
(71) Applicant: Hanwha Solutions Corporation, Jung-gu Seoul 04541 (KR)
(72) Inventor: YI, Min Ji, Seoul 04541 (KR); JEONG, Jun Kyeong, Seoul 04541 (KR); JANG, Eunsoo, Seoul 04541 (KR)
(74) Representative: Mooser, Sebastian Thomas
(86) International application number: PCT/KR2024/018619
(87) International publication number: WO 2025/121753

(57) **Abstract**

The present invention relates to a method for forming an electron transport layer for a perovskite solar cell by performing an atomic layer deposition process under specific temperature conditions, and a method for manufacturing a perovskite solar cell.

## Description

### TECHNICAL FIELD

The present invention relates to a method for forming an electron transport layer for a perovskite solar cell by performing an atomic layer deposition process under specific temperature conditions, and a method for manufacturing a perovskite solar cell.

### BACKGROUND ART

In order to solve the global environmental problems caused by the depletion of fossil fuels and the usage thereof, research on renewable and clean alternative energy sources such as solar energy, wind power and hydropower is actively being conducted.

Among these, interest in solar cells that directly convert electrical energy from sunlight is increasing significantly. Here, a solar cell refers to a cell that generates current-voltage by using the photovoltaic effect that generates electrons and holes by absorbing light energy from sunlight.

Currently, it is possible to manufacture n-p diode-type silicon (Si) single crystal-based solar cells with a light energy conversion efficiency of over 20%, and they are actually being used for solar power generation, and there are also solar cells using compound semiconductors such as gallium arsenide (GaAs) with an even higher conversion efficiency. However, these inorganic semiconductor-based solar cells require highly purified materials to achieve high efficiency, and thus, a lot of energy is consumed in refining the raw materials, and expensive process equipment is required in the process of using the raw materials to make a single crystal or thin film, which limits the cost of lowering the manufacturing cost of solar cells, and this has been an obstacle to large-scale utilization.

Accordingly, in order to manufacture solar cells at low cost, it is necessary to drastically reduce the cost of materials or manufacturing processes used as core elements of solar cells, and research is being conducted on perovskite solar cells that can be manufactured by using low-cost materials and processes as an alternative to inorganic semiconductor-based solar cells.

Recently, perovskite solar cells using (NH₃CH₃)PbX₃ (X = I, Br, Cl), which is a halogen compound with a perovskite structure, as a photoactive agent have been developed, and research is being conducted toward commercialization. The general structural formula of the perovskite structure is the ABX₃ structure, where an anion is located in the X position, a large cation is located in the A position, and a small cation is located in the B position.

Meanwhile, perovskite solar cells are being developed in the structure of P-IN perovskite single solar cell or two-terminal perovskite/silicon tandem solar cell. In the case of two-terminal perovskite/silicon tandem solar cell, a transparent conductive layer is formed on top of a lower silicon solar cell, and then, a hole transport layer, a perovskite light-absorbing layer, an electron transport layer, a transparent electrode and a metal electrode are sequentially formed to manufacture the same.

In this case, an atomic layer deposition (ALD) process can be performed as one of the methods for forming an electron transport layer, and the atomic layer deposition process is generally performed at a temperature of 100°C or higher. However, when forming an electron transport layer through such a high-temperature atomic layer deposition process, there was a problem that the lower organic layer was deteriorated due to the high-temperature reaction and chemical bonding of the source and the reactant.

In addition, when forming an electron transport layer through an atomic layer deposition process at temperatures below 100°C to avoid such problems, there was a problem in that the photoelectric conversion efficiency decreased due to changes in the density and band gap of the electron transport layer formed, which deteriorated the characteristics and charge transfer characteristics of the electron transport layer.

### DISCLOSURE

### TECHNICAL PROBLEM

The present invention has been devised to overcome the above-described problems, and aims to provide a method for forming an electron transport layer for a perovskite solar cell, which not only minimizes heat damage and prevents deterioration occurring at the interface by forming an electron transport layer through an atomic layer deposition process under specific temperature conditions, but also minimizes a decrease in the performance of a perovskite solar cell and ensures stability, and a method for manufacturing a perovskite solar cell.

### TECHNICAL SOLUTION

In order to solve the above-described problems, the method for forming an electron transport layer for a perovskite solar cell according to the present invention may include step 1 of preparing a chamber for an atomic layer deposition process including a substrate therein; step 2 of placing a laminate into the chamber for an atomic layer deposition process to position a laminate on top of the substrate; step 3 of injecting an electron transport layer forming material into the chamber for an atomic layer deposition process; and step 4 of performing an atomic layer deposition process to form an electron transport layer on top of the laminate.

In a preferred embodiment of the present invention, the method for forming an electron transport layer for a perovskite solar cell according to the present invention may satisfy Condition (1) below:
$A > B$ (1)
wherein in Condition (1), A represents a temperature inside the chamber for an atomic layer deposition process, and B represents a temperature of the substrate included inside the chamber for an atomic layer deposition process.

In a preferred embodiment of the present invention, the atomic layer deposition process of step 4 may be performed under conditions where a temperature inside the chamber for an atomic layer deposition process is 85 to 150°C and a temperature of the substrate included inside the chamber for an atomic layer deposition process is 80°C or less.

In a preferred embodiment of the present invention, the atomic layer deposition process of step 4 may be performed under conditions where a temperature inside the chamber for an atomic layer deposition process is 85 to 120°C and a temperature of the substrate included inside the chamber for an atomic layer deposition process is 40 to 70°C.

In a preferred embodiment of the present invention, the laminate may be a structure in which a hole transport layer and a perovskite light-absorbing layer are sequentially laminated, and an electron transport layer may be formed on top of the perovskite light-absorbing layer.

In a preferred embodiment of the present invention, the laminate may have a structure in which a hole transport layer, a perovskite light-absorbing layer and an interlayer are sequentially laminated, and an electron transport layer may be formed on top of the perovskite light-absorbing layer.

In a preferred embodiment of the present invention, the interlayer may include a fullerene-series organic material.

In a preferred embodiment of the present invention, the fullerene-series organic material may include one or more selected from C₆₀, C₇₀, PC60BM and PC70BM.

In a preferred embodiment of the present invention, the electron transport layer may have an average thickness of 3 to 20 nm.

In a preferred embodiment of the present invention, the electron transport layer forming material may include one or more selected from tin oxide (SnOₓ), nickel oxide (NiOₓ), tin oxide (SnO₂), titanium dioxide (TiO₂), zinc oxide (ZnO), barium tin oxide (BaSnO₃), niobium hydroxide (NbOH), hafnium oxide (HfOₓ), zirconium oxide (ZrOₓ), vanadium oxide (VOₓ) and niobium pentoxide (Nb₂O₅).

Meanwhile, the method for manufacturing a perovskite solar cell according to the present invention may include step 1 of manufacturing a laminate by forming a perovskite light-absorbing layer on top of a hole transport layer; step 2 of forming an electron transport layer on top of the perovskite light-absorbing layer through an atomic layer deposition process; and step 3 of sequentially forming a transparent electrode and a metal electrode on top of the electron transport layer.

In a preferred embodiment of the present invention, the atomic layer deposition process of step 2 of the method for manufacturing a perovskite solar cell according to the present invention may be performed by including step 2-1 of preparing a chamber for an atomic layer deposition process including a substrate therein; step 2-2 of placing a laminate into the chamber for an atomic layer deposition process to position a laminate on top of the substrate; step 2-3 of injecting an electron transport layer forming material into the chamber for an atomic layer deposition process; and step 2-4 of performing an atomic layer deposition process to form an electron transport layer on top of the perovskite light-absorbing layer.

Furthermore, the method for manufacturing a perovskite solar cell according to the present invention may include step 1 of manufacturing a laminate by sequentially forming a perovskite light-absorbing layer and an interlayer on top of a hole transport layer; step 2 of forming an electron transport layer on top of the interlayer through an atomic layer deposition process; and step 3 of sequentially forming a transparent electrode and a metal electrode on top of the electron transport layer.

In a preferred embodiment of the present invention, the atomic layer deposition process of step 2 of the method for manufacturing a perovskite solar cell according to the present invention may be performed by including step 2-1 of preparing a chamber for an atomic layer deposition process including a substrate therein; step 2-2 of placing a laminate into the chamber for an atomic layer deposition process to position a laminate on top of the substrate; step 2-3 of injecting an electron transport layer forming material into the chamber for an atomic layer deposition process; and step 2-4 of performing an atomic layer deposition process to form an electron transport layer on top of the interlayer.

In a preferred embodiment of the present invention, the method for manufacturing a perovskite solar cell according to the present invention may satisfy Condition (1) below:
$A > B$ (1)
wherein in Condition (1), A represents a temperature inside the chamber for an atomic layer deposition process, and B represents a temperature of the substrate included inside the chamber for an atomic layer deposition process.

In a preferred embodiment of the present invention, the atomic layer deposition process of step 2-4 of the method for manufacturing a perovskite solar cell according to the present invention may be performed under conditions where a temperature inside the chamber for an atomic layer deposition process is 85 to 150°C and a temperature of the substrate included inside the chamber for an atomic layer deposition process is 80°C or less.

Meanwhile, the method for manufacturing a tandem perovskite solar cell according to the present invention may include step 1 of manufacturing a laminate by sequentially forming a transparent conductive layer, a hole transport layer and a perovskite light-absorbing layer on top of a solar cell; step 2 of forming an electron transport layer on top of the perovskite light-absorbing layer through an atomic layer deposition process; and step 3 of sequentially forming a transparent electrode and a metal electrode on top of the electron transport layer.

In a preferred embodiment of the present invention, the atomic layer deposition process of step 2 of the method for manufacturing a tandem perovskite solar cell according to the present invention may be performed by including step 2-1 of preparing a chamber for an atomic layer deposition process including a substrate therein; step 2-2 of placing a laminate into the chamber for an atomic layer deposition process to position a laminate on top of the substrate; step 2-3 of injecting an electron transport layer forming material into the chamber for an atomic layer deposition process; and step 2-4 of performing an atomic layer deposition process to form an electron transport layer on top of the perovskite light-absorbing layer.

Furthermore, the method for manufacturing a tandem perovskite solar cell according to the present invention may include step 1 of manufacturing a laminate by sequentially forming a transparent conductive layer, a hole transport layer, a perovskite light-absorbing layer and an interlayer on top of a solar cell; step 2 of forming an electron transport layer on top of the interlayer through an atomic layer deposition process; and step 3 of sequentially forming a transparent electrode and a metal electrode on top of the electron transport layer.

In a preferred embodiment of the present invention, the atomic layer deposition process of step 2 of the method for manufacturing a tandem perovskite solar cell according to the present invention may be performed by including step 2-1 of preparing a chamber for an atomic layer deposition process including a substrate therein; step 2-2 of placing a laminate into the chamber for an atomic layer deposition process to position a laminate on top of the substrate; step 2-3 of injecting an electron transport layer forming material into the chamber for an atomic layer deposition process; and step 2-4 of performing an atomic layer deposition process to form an electron transport layer on top of the interlayer.

In a preferred embodiment of the present invention, the method for manufacturing a tandem perovskite solar cell according to the present invention may satisfy Condition (1) below:
$A > B$ (1)
wherein in Condition (1), A represents a temperature inside the chamber for an atomic layer deposition process, and B represents a temperature of the substrate included inside the chamber for an atomic layer deposition process.

In a preferred embodiment of the present invention, the atomic layer deposition process of step 2-4 of the method for manufacturing a tandem perovskite solar cell according to the present invention may be performed under conditions where a temperature inside the chamber for an atomic layer deposition process is 85 to 150°C and a temperature of the substrate included inside the chamber for an atomic layer deposition process is 80°C or less.

In a preferred embodiment of the present invention, the solar cell may be a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fuel-sensitized solar cell or a Group 3-5 compound solar cell.

### ADVANTAGEOUS EFFECTS

The method for forming an electron transport layer for a perovskite solar cell and the method for manufacturing a perovskite solar cell according to the present invention can induce the stabilization of an interface and improve voltage characteristics and fill factor characteristics by enhancing charge transfer characteristics through better aligned energy levels and hole block characteristics, thereby causing an increase in power conversion efficiency.

### DESCRIPTION OF DRAWINGS

FIG. 1 is a schematic diagram showing a chamber for an atomic layer deposition process according to a preferred embodiment of the present invention.
FIG. 2 is an FE-SEM image of the surface of an electron transport layer of a tandem silicon/perovskite heterojunction solar cell manufactured in Example 1.
FIG. 3 is an FE-SEM image of the surface of an electron transport layer of a tandem silicon/perovskite heterojunction solar cell manufactured in Comparative Example 1.

### MODES OF THE INVENTION

Hereinafter, the present invention will be described in more detail.

Perovskite solar cells are being developed in the structure of a P-I-N perovskite single solar cell or two-terminal perovskite/silicon tandem solar cell. In the case of a two-terminal perovskite/silicon tandem solar cell, a transparent conductive layer is formed on top of a lower silicon solar cell, and then, a hole transport layer, a perovskite light-absorbing layer, an electron transport layer, a transparent electrode and a metal electrode are sequentially formed to manufacture the same.

In this case, an atomic layer deposition (ALD) process may be performed as one of the methods for forming an electron transport layer, and the atomic layer deposition process is generally performed at a temperature of 100°C or higher. However, when forming an electron transport layer through such a high-temperature atomic layer deposition process, there was a problem that the lower organic layer was deteriorated due to the high-temperature reaction and chemical bonding of a source and a reactant.

In addition, when forming an electron transport layer through an atomic layer deposition process at temperatures below 100°C to avoid such problems, there was a problem in that the photoelectric conversion efficiency decreased due to changes in the density and band gap of an electron transport layer formed, which deteriorated the characteristics and charge transfer characteristics of the electron transport layer.

Accordingly, the present invention relates to a method for forming an electron transport layer for a perovskite solar cell, which forms an electron transport layer through an atomic layer deposition process under specific temperature conditions, thereby minimizing heat damage and preventing deterioration occurring at an interface, as well as minimizing a decrease in the performance of the perovskite solar cell and ensuring stability, and a method for manufacturing a perovskite solar cell.

The method for forming an electron transport layer for a perovskite solar cell according to the present invention includes steps 1 to 4.

The electron transport layer (ETL) is a layer that transports electrons formed in the perovskite light-absorbing layer while blocking the movement of holes.

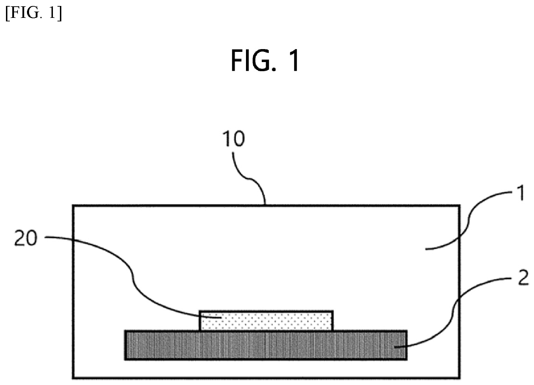

First of all, when it is described by referring to FIG. 1, step 1 of the method for forming an electron transport layer for a perovskite solar cell according to the present invention may be preparing a chamber 10 for an atomic layer deposition (ALD) process including a substrate 2 therein.

Next, step 2 of the method for forming an electron transport layer for a perovskite solar cell according to the present invention may be placing a laminate 20 inside the chamber 10 for an atomic layer deposition process prepared in step 1 to position the laminate 20 on top of the substrate 2.

Next, step 3 of the method for forming an electron transport layer for a perovskite solar cell according to the present invention may be injecting an electron transport layer forming material into the chamber 10 for an atomic layer deposition process.

In this case, the electron transport layer forming material is a material that forms an electron transport layer through an atomic layer deposition process, and may include one or more selected from tin oxide (SnOₓ), nickel oxide (NiOₓ), tin oxide (SnO₂), titanium dioxide (TiO₂), zinc oxide (ZnO), barium tin oxide (BaSnO₃), niobium hydroxide (NbOH), hafnium oxide (HfOₓ), zirconium oxide (ZrOₓ), vanadium oxide (VOₓ) and niobium pentoxide (Nb₂O₅), and preferably, it may include tin oxide (SnO₂).

Finally, step 4 of the method for forming an electron transport layer for a perovskite solar cell according to the present invention may be forming an electron transport layer on top of the laminate 20 introduced into the chamber 10 for an atomic layer deposition process by performing an atomic layer deposition process.

Meanwhile, the laminate 20 may have a structure in which a hole transport layer and a perovskite light-absorbing layer are sequentially laminated, and an electron transport layer may be formed on top of the perovskite light-absorbing layer through step 4 of the method for forming an electron transport layer for a perovskite solar cell.

In addition, the laminate 20 may have a structure in which a hole transport layer, a perovskite light-absorbing layer and an interlayer are sequentially laminated, and an electron transport layer may be formed on top of the interlayer through step 4 of the method for forming an electron transport layer for a perovskite solar cell.

Meanwhile, the method for forming an electron transport layer for a perovskite solar cell according to the present invention may satisfy Condition (1) below.$A > B$ (1)

In Condition (1) above, A represents a temperature inside 1 of the chamber 10 for an atomic layer deposition process, and B represents a temperature of the substrate 2 included inside the chamber 10 for an atomic layer deposition process.

In this way, by satisfying Condition (1) of the present invention and forming an electron transport layer, not only is heat damage minimized and deterioration occurring at the interface prevented, but also the performance reduction of the perovskite solar cell is minimized and stability is secured.

Specifically, the atomic layer deposition process of step 4 of the method for forming an electron transport layer for a perovskite solar cell according to the present invention may be performed under conditions where a temperature inside the chamber 10 for an atomic layer deposition process is 85 to 150°C, and preferably 85 to 120°C, and a temperature of the substrate 2 included inside the chamber 10 for an atomic layer deposition process is 80°C or less, preferably 40°C to 70°C, and more preferably 57°C to 63°C. By forming an electron transport layer while satisfying these temperature conditions, not only can heat damage be minimized and deterioration occurring at the interface be prevented, but also the performance decrease of the perovskite solar cell can be minimized and stability can be secured.

Furthermore, the electron transport layer formed through the method for forming an electron transport layer for a perovskite solar cell according to the present invention may have an average thickness of 3 to 20 nm, preferably an average thickness of 4 to 15 nm, and more preferably an average thickness of 4 to 8 nm. If the average thickness is less than 3 nm, it may be difficult to form a layer with a uniform thickness, which may cause a problem in that the electron transport characteristics may deteriorate. If it is more than 20 nm, not only may the electron transport characteristics decrease, but there may also be a problem in that the series resistance may increase.

The hole transport layer (HTL) included in the laminate 20 is a layer that transports holes formed in the perovskite light-absorbing layer while blocking the movement of electrons, and may include an inorganic and/or organic hole transport material.

In this case, the inorganic hole transport material may include one or more selected from nickel oxide (NiOₓ), CuSCN, CuCrO₂, CuI, CuOₓ, CuS, CuI, CuPc, CIS, CuGaO₂, PbS, MoOx, AlOx (aluminum oxide), CuAlOx, aluminum oxide nanoparticles, silica nanoparticles, nickel oxide nanoparticles, hafnium nanoparticles and V₂O₅.

In addition, the organic hole transport material may include one or more selected from a carbazole derivative, a polyarylalkane derivative, a phenylenediamine derivative, an arylamine derivative, an amino-substituted chalcone derivative, a styrylanthracene derivative, a fluorene derivative, a hydrazone derivative, a stilbene derivative, a silazane derivative, an aromatic tertiary amine compound, a styrylamine compound, an aromatic dimethylidine-based compound, a porphyrin-based compound, a phthalocyanine-based compound, a polythiophene derivative, a polypyrrole derivative, a polyparaphenylenevinylene derivative, pentacene, coumarin 6 (3-(2-benzothiazolyl)-7-(diethylamino)coumarin), ZnPC (zinc phthalocyanine), CuPC (copper phthalocyanine), TiOPC (titanium oxide phthalocyanine), Spiro-MeOTAD (2,2',7,7'-tetrakis(N,N-p-dimethoxyphenylamino)-9,9'-spirobifluorene), F16CuPC (copper(II) 1,2,3,4,8,9,10,11,15,16,17,18,22,23,24,25-hexadecafluoro-29H,31H-phthalocyanine), SubPc (boron subphthalocyanine chloride) and N3 (cis-di(thiocyanato)-bis(2,2'-bipyridyl-4,4'-dicarboxylic acid)-ruthenium(II), P3HT(poly[3-hexylthiophene]), MDMO-PPV (poly[2-methoxy-5-(3',7'-dimethyloctyloxyl)]-1,4-phenylene vinylene), MEH-PPV (poly[2-methoxy-5-(2''-ethylhexyloxy)-p-phenylene vinylene]), P3OT(poly(3-octyl thiophene)), POT(poly(octyl thiophene)), P3DT (poly(3-decyl thiophene)), P3DDT (poly(3-dodecyl thiophene), PPV (poly(p-phenylene vinylene)), TFB (poly(9,9'-dioctylfluorene-co-N-(4-butylphenyl)diphenyl amine), polyaniline, Spiro-MeOTAD ([2,22',7,77'-tetrkis (N,N-di-pmethoxyphenyl amine)-9,9,9'-spirobi fluorine]), PCPDTBT (Poly[2,1,3-benzothiadiazole-4,7-diyl[4,4-bis(2-ethylhexyl-4H-cyclopenta [2,1-b:3,4-b']dithiophene-2,6-diyl]], Si-PCPDTBT (poly[(4,4'-bis(2-ethylhexyl)dithieno[3,2-b:2',3'-d]silole)-2,6-diyl-alt-(2,1,3-benzothiadiazole)-4,7-diyl]), PBDTTPD (poly((4,8-diethylhexyloxyl), PFDTBT (poly[2,7-(9-(2-ethylhexyl)-9-hexyl-fluorene)-alt-5,5-(4', 7, -di-2-thienyl-2',1', 3'-benzothiadiazole)]), PFO-DBT (poly[2,7-.9,9-(dioctyl-fluorene)-alt-5,5-(4',7'-di-2-.thienyl-2', 1', 3'-benzothiadiazole)]), PSiFDTBT (poly[(2,7-dioctylsilafluorene)-2,7-diyl-alt-(4,7-bis(2-thienyl)-2,1,3-benzothiadiazole)-5,5'-diyl]), PCDTBT (Poly [[9-(1-octylnonyl)-9H-carbazole-2,7-diyl]-2,5-thiophenediyl-2,1,3-benzothiadiazole-4,7-diyl-2,5-thiophenediyl]), PFB (poly(9,9'-dioctylfluorene-co-bis(N,N'-(4,butylphenyl))bis(N,N'-phenyl-1,4-phenylene)diamine), F8BT (poly(9,9'-dioctylfluorene-cobenzothiadiazole), PEDOT (poly(3,4-ethylenedioxythiophene)), PEDOT:PSS poly(3,4-ethylenedioxythiophene) poly(styrenesulfonate), PTAA (poly(triarylamine)), 2-PACz, MeO-2PACz, Br-2PACz, Me-4PACz, MeO-4PACz and 6-PACz.

In addition, methods for forming the hole transport layer include a coating method and a vacuum deposition method, and methods for applying the hole transport layer include a gravure coating method, a bar coating method, a printing method, a spray method, a spin coating method, a dip method and a die coat method.

In addition, the thickness of the hole transport layer is not particularly limited, but may preferably have a thickness of 5 nm to 40 nm, and more preferably 10 nm to 30 nm.

The perovskite light-absorbing layer included in the laminate 20 may include a general perovskite material applied to a light-absorbing layer of a solar cell, and as a preferred example, it may include a perovskite material represented by Chemical Formula 1 below.

[Chemical Formula 1] CMX₃

In Chemical Formula 1 above, C is a monovalent cation, which may include an amine, ammonium, a Group 1 metal, a Group 2 metal and/or other cations or cation-like compounds, and preferably, it may be formamidinium (FA), methylammonium (MA), FAMA, CsFAMA, CsFA or N(R)₄⁺ (here, R may be the same or different groups, and R is a straight-chain alkyl group having 1 to 5 carbon atoms, a branched alkyl group having 3 to 5 carbon atoms, a phenyl group, an alkylphenyl group, an alkoxyphenyl group or an alkyl halide).

In addition, M in Chemical Formula 1 is a divalent cation, and may include one or two selected from Fe, Co, Ni, Cu, Sn, Pb, Bi, Ge, Ti, Eu and Zr.

In addition, X in Chemical Formula 1 is a monovalent anion, and may include one or more halide elements selected from F, Cl, Br and I and/or a Group 16 anion. As a preferred example, X may be IₓBr₃₋ₓ (0 ≤ x ≤ 3).

In addition, a preferable embodiment of Chemical Formula 1 may be FAPbIₓBr₃₋ₓ (0 ≤ x ≤ 3), MAPbIₓBr₃₋ₓ (0 ≤ x ≤ 3), CSFAPbIₓBr₃₋ₓ (0 ≤ x ≤ 3), CSMAFAPbIₓBr₃₋ₓ (0 ≤ x ≤ 3), CH₃NH₃PbX₃ (X= Cl, Br, I, BrI₂, or Br₂I), CH₃NH₃SnX₃ (X= Cl, Br or I), CH(=NH)NH₃PbX₃ (X= Cl, Br, I, BrI₂, or Br₂I) or CH(=NH)NH₃SnX₃ (X= Cl, Br or I).

Meanwhile, the perovskite light-absorbing layer may be a single layer composed of the same perovskite material, or may be a multilayer structure in which multiple layers composed of different perovskite materials are laminated, and may include a heterogeneous perovskite material other than the one type of perovskite material having a pillar shape such as a column shape, a plate shape, a needle shape, a wire shape or a rod shape inside the light-absorbing layer composed of the one type of perovskite material.

In addition, methods for forming the perovskite light-absorbing layer include a coating method and a vacuum deposition method, and methods for applying the layer include a gravure coating method, a bar coating method, a printing method, a spray method, a spin coating method, a dip method, an inkjet coating method and a die coat method.

In addition, the thickness of the perovskite light-absorbing layer is not particularly limited, but may preferably have a thickness of 50 nm to 800 nm, and more preferably 300 nm to 600 nm.

The interlayer included in the laminate 20 may include a fullerene-series organic material. In this case, the fullerene-series organic material may include one or more selected from C₆₀, C₇₀, PC60BM and PC70BM, and preferably, it may include C₆₀. In addition, the interlayer included in the laminate 20 may further include lithium fluoride (LiF).

In addition, the interlayer may have an average thickness of 3 to 30 nm, preferably an average thickness of 5 to 20 nm, and more preferably an average thickness of 11 to 17 nm. If the average thickness is less than 3 nm, the interlayer may not be uniformly formed on the rough surface of the perovskite light-absorbing layer, which may cause a problem of reduced charge transfer capability. In addition, if the average thickness is more than 30 nm, the interlayer may absorb light that should be absorbed by the perovskite light-absorbing layer, thereby hindering the light-receiving characteristics of the perovskite light-absorbing layer, which may cause a problem of reduced characteristics of the solar cell.

Meanwhile, the method for manufacturing a perovskite solar cell according to the present invention includes steps 1 to 3.

First of all, in step 1 of the method for manufacturing a perovskite solar cell according to the present invention, a laminate may be manufactured by forming a perovskite light-absorbing layer on top of a hole transport layer. In this case, the hole transport layer and the perovskite light-absorbing layer are the same as described above.

Next, in step 2 of the method for manufacturing a perovskite solar cell according to the present invention, an electron transport layer may be formed on the perovskite light-absorbing layer formed in step 1 through an atomic layer deposition process. As described above, the electron transporting layer (ETL) is a layer that transports electrons formed in the perovskite light-absorbing layer and simultaneously blocks the movement of holes.

Specifically, the atomic layer deposition process of step 2 of the method for manufacturing a perovskite solar cell according to the present invention includes steps 2-1 to 2-4.

Referring to FIG. 1, step 2-1 of the method for manufacturing a perovskite solar cell according to the present invention may prepare a chamber 10 for an atomic layer deposition (ALD) process including a substrate 2 therein.

Next, in step 2-2 of the method for manufacturing a perovskite solar cell according to the present invention, the laminate 20 may be placed inside the chamber 10 for an atomic layer deposition process prepared in step 1, and the laminate 20 may be positioned on top of the substrate 2.

Next, in step 2-3 of the method for manufacturing a perovskite solar cell according to the present invention, a material for forming an electron transport layer may be injected into the chamber 10 for an atomic layer deposition process.

In this case, the electron transport layer forming material is a material that forms the electron transport layer through an atomic layer deposition process, and may include one or more selected from tin oxide (SnOₓ), nickel oxide (NiOₓ), tin oxide (SnO₂), titanium dioxide (TiO₂), zinc oxide (ZnO), barium tin oxide (BaSnO₃), niobium hydroxide (NbOH), hafnium oxide (HfOₓ), zirconium oxide (ZrOₓ), vanadium oxide (VOₓ), and niobium pentoxide (Nb₂O₅), and preferably, it may include tin oxide (SnO ₂ ).

Finally, in step 2-4 of the method for manufacturing a perovskite solar cell according to the present invention, an atomic layer deposition process may be performed to form an electron transport layer on top of a laminate 20 placed inside the chamber 10 for an atomic layer deposition process.

Meanwhile, the laminate 20 may have a structure in which a hole transport layer and a perovskite light-absorbing layer are sequentially laminated, and an electron transport layer may be formed on top of the perovskite light-absorbing layer through steps 2-4 of the method for manufacturing a perovskite solar cell according to the present invention.

In addition, the method for manufacturing a perovskite solar cell according to the present invention may Condition (1) below.$A > B$ (1)

In Condition (1) above, A represents a temperature inside 1 of the chamber 10 for an atomic layer deposition process, and B represents a temperature of the substrate 2 included inside the chamber 10 for the atomic layer deposition process.

In this way, by satisfying Condition (1) of the present invention and forming an electron transport layer, not only is heat damage minimized and deterioration occurring at the interface prevented, but also the performance reduction of the perovskite solar cell is minimized and stability is secured.

Specifically, the atomic layer deposition process of step 2-4 of the method for manufacturing a perovskite solar cell according to the present invention may be performed under conditions where a temperature inside the chamber 10 for the atomic layer deposition process 1 is 85 to 150°C, and preferably 85 to 120°C, and a temperature of the substrate 2 included inside the chamber 10 for the atomic layer deposition process is 80°C or less, preferably 40°C to 70°C, and more preferably 57°C to 63°C. By forming an electron transport layer while satisfying these temperature conditions, not only can heat damage be minimized and deterioration occurring at the interface be prevented, but also the performance decrease of the perovskite solar cell can be minimized and stability can be secured.

Furthermore, the electron transport layer formed through step 2 of the method for manufacturing a perovskite solar cell according to the present invention may have an average thickness of 3 to 20 nm, preferably an average thickness of 4 to 15 nm, and more preferably an average thickness of 4 to 8 nm. If the average thickness is less than 3 nm, it may be difficult to form a layer with a uniform thickness, which may cause a problem in that the electron transport characteristics may deteriorate. If it is more than 20 nm, not only may the electron transport characteristics decrease, but there may also be a problem in that the series resistance may increase.

Next, in step 3 of the method for manufacturing a perovskite solar cell according to the present invention, a transparent electrode and a metal electrode may be sequentially formed on top of the electron transport layer formed in step 2.

The transparent electrode may be formed on top of the electron transport layer through a deposition process. In this case, the deposition may be performed by using a general deposition process used in the art, and preferably, the deposition process may be performed by using a sputtering method.

In addition, the transparent electrode may be a transparent thin film deposited with ITO (Indium Tin Oxide), FTO (Fluorine doped Tin Oxide), ATO (Sb₂O₃ doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide) or AZO (Aluminum doped zinc oxide).

In addition, there is no separate limitation on the thickness of the transparent electrode, but it may preferably have a thickness of 50 to 200 nm, and more preferably 60 to 140 nm.

The metal electrode may be formed by patterning a metal material on top of a transparent electrode. Specifically, the patterning process is largely composed of deposition, exposure (lithography) and etching. The metal electrode may be formed on top of the transparent electrode through the process of spreading a metal material in the form of a thin film on one surface of a substrate, printing a pattern by exposure, and then removing unnecessary portions. In addition, the patterning process may also be performed through a screen printing method using a metal paste including a metal material.

In this case, the metal material may include one or more selected from Pt, Au, Ni, Cu, Ag, In, Ru, Pd, Rh, Ir, Os, C and a conductive polymer.

In addition, there is no separate limitation on the thickness of the metal electrode, but it may preferably have a thickness of 50 nm to 2.5 µm.

Meanwhile, as another method, the method for manufacturing a perovskite solar cell according to the present invention includes steps 1 to 3.

First of all, in step 1 of the method for manufacturing a perovskite solar cell according to the present invention, a laminate may be manufactured by sequentially forming a perovskite light-absorbing layer and an interlayer on top of a hole transport layer. In this case, the hole transport layer, the perovskite light-absorbing layer and the interlayer are the same as described above.

Next, in step 2 of the method for manufacturing a perovskite solar cell according to the present invention, an electron transport layer may be formed on top of the interlayer formed in step 1 through an atomic layer deposition process. As described above, the electron transport layer (ETL) is a layer that transports electrons formed in the perovskite light-absorbing layer and simultaneously blocks the movement of holes.

Specifically, the atomic layer deposition process of step 2 of the method for manufacturing a perovskite solar cell according to the present invention includes steps 2-1 to 2-4.

Referring to FIG. 1, step 2-1 of the method for manufacturing a perovskite solar cell according to the present invention may prepare a chamber 10 for an atomic layer deposition (ALD) process including a substrate 2 inside.

Next, in step 2 of the method for manufacturing a perovskite solar cell according to the present invention, the laminate 20 may be placed inside the chamber 10 for an atomic layer deposition process prepared in step 1, and the laminate 20 may be positioned on top of the substrate 2.

Next, in step 2-3 of the method for manufacturing a perovskite solar cell according to the present invention, a material for forming an electron transport layer may be injected into the chamber 10 for an atomic layer deposition process.

In this case, the electron transport layer forming material is a material that forms the electron transport layer through an atomic layer deposition process, and may include one or more selected from tin oxide (SnOₓ), nickel oxide (NiOₓ), tin oxide (SnO₂), titanium dioxide (TiO₂), zinc oxide (ZnO), barium tin oxide (BaSnO₃), niobium hydroxide (NbOH), hafnium oxide (HfOₓ), zirconium oxide (ZrOₓ), vanadium oxide (VOₓ) and niobium pentoxide (Nb₂O₅), and preferably, it may include tin oxide (SnO₂).

Finally, in step 2-4 of the method for manufacturing a perovskite solar cell according to the present invention, an atomic layer deposition process may be performed to form an electron transport layer on top of the laminate 20 placed inside the chamber 10 for an atomic layer deposition process.

Meanwhile, the laminate 20 may have a structure in which a hole transport layer, a perovskite light-absorbing layer and an interlayer are sequentially laminated, and an electron transport layer may be formed on top of the interlayer through steps 2-4 of the method for manufacturing a perovskite solar cell according to the present invention.

In addition, the method for manufacturing a perovskite solar cell according to the present invention may satisfy Condition (1) below.$A > B$ (1)

In Condition (1) above, A represents a temperature inside 1 of the chamber 10 for an atomic layer deposition process, and B represents a temperature of the substrate 2 included inside the chamber 10 for an atomic layer deposition process.

In this way, by satisfying Condition (1) of the present invention and forming an electron transport layer, not only is heat damage minimized and deterioration occurring at the interface prevented, but also the performance reduction of the perovskite solar cell is minimized and stability is secured.

Specifically, the atomic layer deposition process of steps 2-4 of the method for manufacturing a perovskite solar cell according to the present invention may be performed under conditions where a temperature inside 1 the chamber 10 for an atomic layer deposition process is 85 to 150°C, and preferably 85 to 120°C, and the temperature of the substrate 2 included inside the chamber 10 for an atomic layer deposition process is 80°C or less, preferably 40°C to 70°C, and more preferably 57°C to 63°C. By forming an electron transport layer while satisfying these temperature conditions, not only can heat damage be minimized and deterioration occurring at the interface be prevented, but also the performance decrease of the perovskite solar cell can be minimized and stability can be secured.

Furthermore, the electron transport layer formed through step 2 of the method for manufacturing a perovskite solar cell according to the present invention may have an average thickness of 3 to 20 nm, preferably an average thickness of 4 to 15 nm, and more preferably an average thickness of 4 to 8 nm. If the average thickness is less than 3 nm, it may be difficult to form a layer with a uniform thickness, which may cause a problem in that the electron transport characteristics may deteriorate. If it is more than 20 nm, not only may the electron transport characteristics decrease, but there may also be a problem in that the series resistance may increase.

Next, in step 3 of the method for manufacturing a perovskite solar cell according to the present invention, a transparent electrode and a metal electrode may be sequentially formed on the electron transport layer formed in step 2. In this case, the transparent electrode and the metal electrode are the same as described above.

Furthermore, the method for manufacturing a tandem perovskite solar cell according to the present invention includes steps 1 to 3.

First of all, in step 1 of the method for manufacturing a tandem perovskite solar cell according to the present invention, a laminate may be manufactured by sequentially forming a transparent conductive layer, a hole transport layer and a perovskite light-absorbing layer on top of a solar cell. In this case, the hole transport layer and the perovskite light-absorbing layer are the same as described above.

The solar cell may be a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fluorine-sensitized solar cell or a Group 3-5 compound solar cell.

In addition, there is no separate limitation on the thickness of the solar cell, but it may preferably have a thickness of 140 to 250 µm, and more preferably 160 to 200 µm.

The transparent conductive layer is a layer that induces the recombination of electrons and holes generated in the solar cell and the perovskite light-absorbing layer, and may be a transparent thin film on which ITO (Indium Tin Oxide), FTO (Fluorine doped Tin Oxide), ATO (Sb₂O₃doped Tin Oxide), GTO (Gallium doped Tin Oxide), ZTO (tin doped zinc oxide), ZTO:Ga (gallium doped ZTO), IGZO (Indium gallium zinc oxide), IZO (Indium doped zinc oxide), or AZO (Aluminum doped zinc oxide) is deposited.

In addition, as an example of forming a transparent conductive layer, when using a silicon solar cell doped with n or p-type impurities as a solar cell, the silicon solar cell doped with n or p-type impurities is treated with hydrofluoric acid to remove the SiOₓ oxide film, and then, the remaining hydrofluoric acid is removed by using ultrapure water. Then, a transparent conductive layer may be formed on top of the silicon solar cell from which the oxide film has been removed through a sputtering process.

In addition, the thickness of the transparent conductive layer is not particularly limited, but may preferably have a thickness of 5 nm to 50 nm, and more preferably 15 nm to 25 nm.

Next, in step 2 of the method for manufacturing a tandem perovskite solar cell according to the present invention, an electron transport layer may be formed on the perovskite light-absorbing layer formed in step 1 through an atomic layer deposition process. As described above, the electron transporting layer (ETL) is a layer that transports electrons formed in the perovskite light-absorbing layer and simultaneously blocks the movement of holes.

Specifically, the atomic layer deposition process of step 2 of the method for manufacturing a tandem perovskite solar cell according to the present invention includes steps 2-1 to 2-4.

Referring to FIG. 1, step 2 of the method for manufacturing a tandem perovskite solar cell according to the present invention may be preparing a chamber 10 for an atomic layer deposition (ALD) process including a substrate 2 therein.

Next, in step 2 of the method for manufacturing a tandem perovskite solar cell according to the present invention, the laminate 20 may be placed inside the chamber 10 for an atomic layer deposition process prepared in step 1, and the laminate 20 may be positioned on top of the substrate 2.

Next, in step 2-3 of the method for manufacturing a tandem perovskite solar cell according to the present invention, a material for forming an electron transport layer may be injected into the chamber 10 for an atomic layer deposition process.

In this case, the electron transport layer forming material is a material that forms the electron transport layer through an atomic layer deposition process, and may include one or more selected from tin oxide (SnOₓ), nickel oxide (NiOₓ), tin oxide (SnO₂), titanium dioxide (TiO₂), zinc oxide (ZnO), barium tin oxide (BaSnO₃), niobium hydroxide (NbOH), hafnium oxide (HfOₓ), zirconium oxide (ZrOₓ), vanadium oxide (VOₓ) and niobium pentoxide (Nb₂O₅), and preferably, it may include tin oxide (SnO₂).

Finally, in step 2-4 of the method for manufacturing a tandem perovskite solar cell according to the present invention, an atomic layer deposition process may be performed to form an electron transport layer on top of a laminate 20 placed inside a chamber 10 for an atomic layer deposition process.

Meanwhile, the laminate 20 may have a structure in which a solar cell, a transparent conductive layer, a hole transport layer and a perovskite light-absorbing layer are sequentially laminated, and an electron transport layer may be formed on top of the perovskite light-absorbing layer through step 2-4 of the method for manufacturing a tandem perovskite solar cell according to the present invention.

In addition, the method for manufacturing a tandem perovskite solar cell according to the present invention may satisfy Condition (1) below.$A > B$ (1)

In Condition (1) above, A represents a temperature inside 1 of the chamber 10 for an atomic layer deposition process, and B represents a temperature of the substrate 2 included inside the chamber 10 for an atomic layer deposition process.

In this way, by satisfying Condition (1) of the present invention and forming an electron transport layer, not only is heat damage minimized and deterioration occurring at the interface prevented, but also the performance reduction of the perovskite solar cell is minimized and stability is secured.

Specifically, the atomic layer deposition process of step 2-4 of the method for manufacturing a tandem perovskite solar cell according to the present invention may be performed under conditions where a temperature inside 1 the chamber 10 for an atomic layer deposition process is 85 to 150°C, and preferably 85 to 120°C, and a temperature of the substrate 2 included inside the chamber 10 for an atomic layer deposition process is 80°C or less, preferably 40°C to 70°C, and more preferably 57°C to 63°C. By forming an electron transport layer while satisfying these temperature conditions, not only can heat damage be minimized and deterioration occurring at the interface be prevented, but also the performance decrease of the perovskite solar cell can be minimized and stability can be secured.

Furthermore, the electron transport layer formed through step 2 of the method for manufacturing a tandem perovskite solar cell according to the present invention may have an average thickness of 3 to 20 nm, preferably an average thickness of 4 to 15 nm, and more preferably an average thickness of 4 to 8 nm. If the average thickness is less than 3 nm, it is difficult to form a layer with a uniform thickness, which may cause a problem in that the electron transport characteristics deteriorate, and if it is more than 20 nm, not only the electron transport characteristics decrease, but also the series resistance may increase.

Next, in step 3 of the method for manufacturing a tandem perovskite solar cell according to the present invention, a transparent electrode and a metal electrode may be sequentially formed on top of the electron transport layer formed in step 2. In this case, the transparent electrode and the metal electrode are the same as described above.

Furthermore, as another method, the method for manufacturing a tandem perovskite solar cell according to the present invention includes steps 1 to 3.

First of all, in step 1 of the method for manufacturing a tandem perovskite solar cell according to the present invention, a laminate may be manufactured by sequentially forming a transparent conductive layer, a hole transport layer, a perovskite light-absorbing layer and an interlayer on top of a solar cell. In this case, the solar cell, the transparent conductive layer, the hole transport layer, the perovskite light-absorbing layer and the interlayer are the same as described above.

Next, in step 2 of the method for manufacturing a tandem perovskite solar cell according to the present invention, an electron transport layer may be formed on top of the interlayer formed in step 1 through an atomic layer deposition process. As described above, the electron transport layer (ETL) is a layer that transports electrons formed in the perovskite light-absorbing layer and simultaneously blocks the movement of holes.

Specifically, the atomic layer deposition process of step 2 of the method for manufacturing a tandem perovskite solar cell according to the present invention includes steps 2-1 to 2-4.

Referring to FIG. 1, step 2 of the method for manufacturing a tandem perovskite solar cell according to the present invention may be preparing a chamber 10 for an atomic layer deposition (ALD) process including a substrate 2 therein.

Next, in step 2 of the method for manufacturing a tandem perovskite solar cell according to the present invention, the laminate 20 may be placed inside the chamber 10 for an atomic layer deposition process prepared in step 1, and the laminate 20 may be positioned on top of the substrate 2.

Next, in step 2-3 of the method for manufacturing a tandem perovskite solar cell according to the present invention, a material for forming an electron transport layer may be injected into the chamber 10 for an atomic layer deposition process.

In this case, the electron transport layer forming material is a material that forms the electron transport layer through an atomic layer deposition process, and may include one or more selected from tin oxide (SnOₓ), nickel oxide (NiOₓ), tin oxide (SnO₂), titanium dioxide (TiO₂), zinc oxide (ZnO), barium tin oxide (BaSnO₃), niobium hydroxide (NbOH), hafnium oxide (HfOₓ), zirconium oxide (ZrOₓ), vanadium oxide (VOₓ) and niobium pentoxide (Nb₂O₅), and preferably, it may include tin oxide (SnO₂).

Finally, in step 2-4 of the method for manufacturing a tandem perovskite solar cell according to the present invention, an atomic layer deposition process may be performed to form an electron transport layer on top of a laminate 20 placed inside a chamber 10 for an atomic layer deposition process.

Meanwhile, the laminate 20 may have a structure in which a solar cell, a transparent conductive layer, a hole transport layer, a perovskite light-absorbing layer and an interlayer are sequentially laminated, and an electron transport layer may be formed on top of the interlayer through step 2-4 of the method for manufacturing a tandem perovskite solar cell according to the present invention.

In addition, the method for manufacturing a tandem perovskite solar cell according to the present invention may satisfy Condition (1) below.$A > B$ (1)

In Condition (1) above, A represents a temperature inside 1 of the chamber 10 for an atomic layer deposition process, and B represents a temperature of the substrate 2 included inside the chamber 10 for the atomic layer deposition process.

In this way, by satisfying Condition (1) of the present invention and forming an electron transport layer, not only is heat damage minimized and deterioration occurring at the interface prevented, but also the performance reduction of the perovskite solar cell is minimized and stability is secured.

Specifically, the atomic layer deposition process of step 2-4 of the method for manufacturing a tandem perovskite solar cell according to the present invention may be performed under conditions where a temperature inside 1 the chamber 10 for an atomic layer deposition process is 85 to 150°C, and preferably 85 to 120°C, and a temperature of the substrate 2 included inside the chamber 10 for an atomic layer deposition process is 80°C or less, preferably 40°C to 70°C, and more preferably 57°C to 63°C. By forming an electron transport layer while satisfying these temperature conditions, not only can heat damage be minimized and deterioration occurring at the interface be prevented, but also the performance decrease of the perovskite solar cell can be minimized and stability can be secured.

Furthermore, the electron transport layer formed through step 2 of the method for manufacturing a tandem perovskite solar cell according to the present invention may have an average thickness of 3 to 20 nm, preferably an average thickness of 4 to 15 nm, and more preferably an average thickness of 4 to 8 nm. If the average thickness is less than 3 nm, it is difficult to form a layer with a uniform thickness, which may cause a problem in that the electron transport characteristics deteriorate, and if it is more than 20 nm, not only the electron transport characteristics decrease, but also the series resistance may increase.

Next, in step 3 of the method for manufacturing a tandem perovskite solar cell according to the present invention, a transparent electrode and a metal electrode may be sequentially formed on top of the electron transport layer formed in step 2. In this case, the transparent electrode and the metal electrode are the same as described above.

Hereinafter, the present invention will be described more specifically through examples, but the following examples do not limit the scope of the present invention, and should be interpreted as helping to understand the present invention.

### Example 1: Manufacture of tandem silicon/perovskite heterojunction solar cell

(1) A silicon solar cell (thickness: 180 µm) doped with n or p-type impurities was prepared, a SiOₓ oxide film was removed by hydrofluoric acid treatment, and the remaining hydrofluoric acid was removed by using ultrapure water. A 20 nm thick transparent conductive layer (ITO) was formed on top of the silicon solar cell from which the oxide film had been removed through a sputtering process.
(2) Next, nickel oxide (NiOₓ) with a thickness of 20 nm was deposited on top of the transparent conductive layer through a sputtering vacuum deposition method, and Me-4PACz with a thickness of 5 nm was coated on top of the nickel oxide deposited through spin coating to form a hole transport layer.
(3) Next, a yellow light-absorbing layer solution dissolved in dimethylformamide (DMF) and dimethyl sulfoxide (DMSO) was formed on top of the hole transport layer through spin coating, and a perovskite light-absorbing layer (CSFAPbIₓBr_{3-X} (0 ≤ x ≤ 3)) having a perovskite crystal structure with a thickness of 400 nm was formed by heat treatment at 150°C for 10 minutes.
(4) Next, lithium fluoride (LiF) having an average thickness of 1 nm was deposited on top of the perovskite light-absorbing layer through a vacuum deposition process, and C₆₀ fullerene having an average thickness of 15 nm was deposited on top of the lithium fluoride deposited through the vacuum deposition process to form an interlayer, thereby manufacturing a laminate.
(5) As shown in FIG. 1, a chamber 10 for an atomic layer deposition (ALD) process including a substrate 2 therein was prepared, and a laminate 20 was placed inside the atomic layer deposition process chamber 10. In this case, the laminate 20 was positioned on top of the substrate 2 such that the silicon solar cell of the laminate 20 and the substrate 2 were in contact with each other. An electron transport layer forming material was injected into the chamber 10 for an atomic layer deposition process, and the atomic layer deposition process was performed for 15 minutes, thereby forming an electron transport layer with an average thickness of 6 nm on top of the laminate 20. In this case, the atomic layer deposition process was performed under conditions that a temperature inside 1 the chamber 10 for an atomic layer deposition process was 110°C and a temperature of the substrate 2 was 60°C. In addition, tin oxide (SnO₂) was used as the electron transport layer forming material.
(6) Next, a 75 nm thick transparent electrode (ITO) was formed on top of the electron transport layer through a sputtering process.
(7) Finally, silver (Ag) was deposited on top of the transparent electrode at a pressure of 1 × 10⁻⁷ torr to a thickness of 100 nm to form a metal electrode, thereby manufacturing a tandem silicon/perovskite heterojunction solar cell in which a silicon solar cell, a transparent conductive layer, a hole transport layer, a perovskite light-absorbing layer, an interlayer, an electron transport layer, a transparent electrode and a metal electrode were sequentially laminated.

### Example 2: Manufacture of tandem silicon/perovskite heterojunction solar cell

A tandem silicon/perovskite heterojunction solar cell was manufactured by using the same method as in Example 1. However, unlike Example 1, when forming an electron transport layer using a chamber for an atomic layer deposition process, the atomic layer deposition process was performed under conditions where a temperature inside the chamber for an atomic layer deposition process was 110°C and a temperature of the substrate was 75°C.

### Example 3: Manufacture of tandem silicon/perovskite heterojunction solar cell

A tandem silicon/perovskite heterojunction solar cell was manufactured by using the same method as in Example 1. However, unlike Example 1, when forming an electron transport layer using a chamber for an atomic layer deposition process, the electron transport layer was formed to have an average thickness of 10 nm.

### Example 4: Manufacture of tandem silicon/perovskite heterojunction solar cell

A tandem silicon/perovskite heterojunction solar cell was manufactured by using the same method as in Example 2. However, unlike Example 2, when forming an electron transport layer using a chamber for an atomic layer deposition process, the electron transport layer was formed to have an average thickness of 10 nm.

### Comparative Example 1: Manufacture of tandem silicon/perovskite heterojunction solar cell

A tandem silicon/perovskite heterojunction solar cell was manufactured by using the same method as in Example 1. However, unlike Example 1, when forming an electron transport layer using a chamber for an atomic layer deposition process, the atomic layer deposition process was performed under conditions where a temperature inside the atomic layer deposition process chamber was 110°C and a temperature of the substrate was 110°C.

### Experimental Example 1: Surface SEM image analysis of electron transport layer included in solar cell

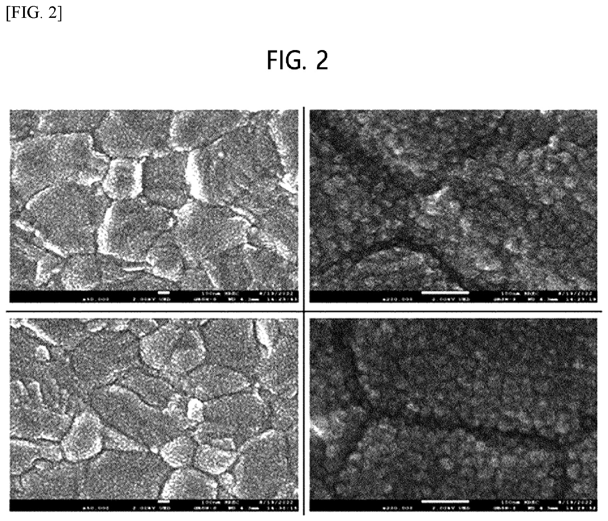

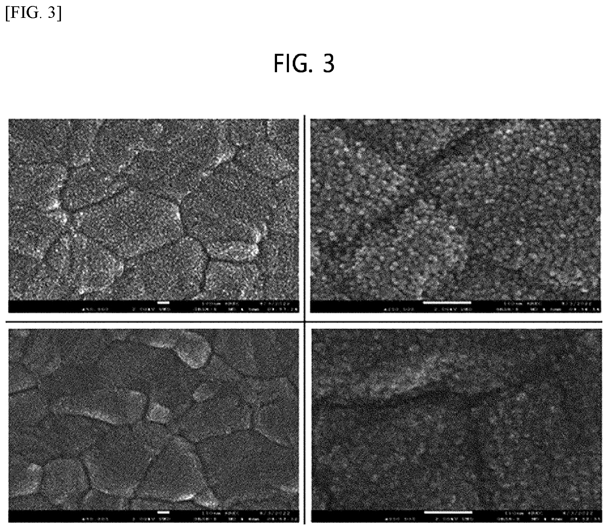

In Example 1, when manufacturing a tandem silicon/perovskite heterojunction solar cell, immediately after forming the electron transport layer, an image of the surface of the electron transport layer was taken by using a field emission scanning electron microscope, and the taken FE-SEM image is shown in FIG. 2. Additionally, in Comparative Example 1, when manufacturing a tandem silicon/perovskite heterojunction solar cell, immediately after forming the electron transport layer, an image of the surface of the electron transport layer was taken by using a field emission scanning electron microscope, and the taken FE-SEM image is shown in FIG. 3.

As can be confirmed in FIGS. 2 and 3, it was confirmed that similar grains were observed in the electron transport layer of Example 1 and the electron transport layer of Comparative Example 1, and through this, it was confirmed that when the electron transport layer was formed by using the chamber for an atomic layer deposition process, even under the conditions where a temperature inside the chamber for an atomic layer deposition process was 110°C and a temperature of the substrate was 60°C, the electron transport layer was formed similarly to the conditions where a temperature inside the chamber for an atomic layer deposition process was 110°C and a temperature of the substrate was 110°C.

### Experimental Example 2: Analysis of surface chemical properties of electron transport layer

The surface chemical properties of the electron transport layer of each of the tandem silicon/perovskite heterojunction solar cells manufactured in Example 1 and Comparative Example 1 were analyzed by using photoelectron spectroscopy (XPS), and the results are shown in Table 1 below.

**[Table 1]**

| Classification | WF | VBM | O | Sn | O/Sn |
|---|---|---|---|---|---|
| Example 1 | 5.15 | 2.67 | 53.5 | 27.3 | 1.96 |
| Comparative Example 1 | 5.24 | 2.58 | 52.2 | 28.2 | 1.85 |

As can be confirmed in Table 1 above, it was confirmed that the tandem silicon/perovskite heterojunction solar cell manufactured in Example 1 had an increased valence band maximum (VBM), a decreased work function (WF), and an increased O/Sn ratio compared to the tandem silicon/perovskite heterojunction solar cell manufactured in Comparative Example 1. As the valence band maximum (VBM) increased and the work function (WF) decreased, the energy level matching and electron transport characteristics became favorable, which could improve the power conversion efficiency through the improvement of an open-circuit voltage. In addition, it was confirmed that the oxygen (O) ratio increased and the defect states above the valence band maximum (VBM) decreased, which could enhance the hole block characteristics.

### Experimental Example 3: Measurement of solar cell performance

For each of the tandem silicon/perovskite heterojunction solar cells manufactured in Examples 1 to 4 and Comparative Example 1, the efficiency was measured by using a solar simulation device, a JV Keithley device and the initial JV curve. After storing the solar cells in a desiccator for 9 days, the JV curve was measured to measure a change in the solar cell characteristics after aging, and the results are shown in Table 2 below.

**[Table 2]**

| Classification | Aging time (day) | Open-circuit voltage (V_{OC}, V) | Short-circuit current density (J_{SC}, mA/cm² ) | Fill factor (FF) | Power conversion efficiency (PCE, %) | Series resistance (Rₛ, Ω) | Parallel resistance (R_{sh,} Ω) | Hysteresis (%) |
|---|---|---|---|---|---|---|---|---|
| Example 1 | 1 | 1.875 | 19.83 | 77.55 | 28.88 | 4.35 | 2,176 | 4.07 |
| | 9 | 1.836 | 19.88 | 79.30 | 28.94 | 3.78 | 2,780 | 2.99 |
| Example 2 | 1 | 1.841 | 19.68 | 78.90 | 28.62 | 3.65 | 2,875 | 2.84 |
| | 9 | 1.823 | 19.69 | 78.56 | 28.22 | 3.71 | 2,767 | 2.64 |
| Example 3 | 1 | 1.853 | 19.57 | 78.66 | 28.52 | 4.34 | 2,989 | 3.57 |
| | 9 | 1.826 | 19.61 | 78.39 | 28.20 | 4.25 | 2,960 | 3.26 |
| Example 4 | 1 | 1.825 | 19.63 | 79.32 | 28.52 | 3.72 | 2,972 | 3.37 |
| | 9 | 1.808 | 19.67 | 79.48 | 28.39 | 3.69 | 3,232 | 2.88 |
| Comparative Example 1 | 1 | 1.815 | 19.83 | 77.01 | 27.71 | 4.09 | 2,026 | 4.74 |
| | 9 | 1.795 | 19.87 | 77.80 | 27.75 | 4.03 | 2,466 | 3.46 |

As can be confirmed in Table 2 above, it was confirmed that the tandem silicon/perovskite heterojunction solar cell manufactured in Example 1 exhibited the best power conversion efficiency.

The above has been illustrated and described with respect to specific embodiments. However, it is not limited to the above-described embodiments, and those skilled in the art to which the invention pertains can make various modifications and implementations without departing from the gist of the technical concept of the invention described in the claims below.

## Claims

1. A method for forming an electron transport layer for a perovskite solar cell, the method comprising:
step 1 of preparing a chamber for an atomic layer deposition process comprising a substrate therein;
step 2 of placing a laminate into the chamber for an atomic layer deposition process to position a laminate on top of the substrate;
step 3 of injecting an electron transport layer forming material into the chamber for an atomic layer deposition process; and
step 4 of performing an atomic layer deposition process to form an electron transport layer on top of the laminate,
wherein Condition (1) below is satisfied: $A > B$ (1)
wherein in Condition (1), A represents a temperature inside the chamber for an atomic layer deposition process, and B represents a temperature of the substrate comprised inside the chamber for an atomic layer deposition process.

2. The method of claim 1, wherein the atomic layer deposition process of step 4 is performed under conditions where a temperature inside the chamber for an atomic layer deposition process is 85 to 150°C and a temperature of the substrate comprised inside the chamber for an atomic layer deposition process is 80°C or less.

3. The method of claim 2, wherein the atomic layer deposition process of step 4 is performed under conditions where a temperature inside the chamber for an atomic layer deposition process is 85 to 120°C and a temperature of the substrate comprised inside the chamber for an atomic layer deposition process is 40 to 70°C.

4. The method of claim 1, wherein the laminate has a structure in which a hole transport layer and a perovskite light-absorbing layer are sequentially laminated, and
wherein an electron transport layer is formed on top of the perovskite light-absorbing layer.

5. The method of claim 1, wherein the laminate has a structure in which a hole transport layer, a perovskite light-absorbing layer and an interlayer are sequentially laminated, and
wherein an electron transport layer is formed on top of the perovskite light-absorbing layer.

6. The method of claim 5, wherein the interlayer comprises a fullerene-series organic material.

7. The method of claim 6, wherein the fullerene-series organic material comprises one or more selected from C₆₀, C₇₀, PC60BM and PC70BM.

8. The method of claim 1, wherein the electron transport layer has an average thickness of 3 to 20 nm.

9. The method of claim 1, wherein the electron transport layer forming material comprises one or more selected from tin oxide (SnOₓ), nickel oxide (NiOₓ), tin oxide (SnO₂), titanium dioxide (TiO₂), zinc oxide (ZnO), barium tin oxide (BaSnO₃), niobium hydroxide (NbOH), hafnium oxide (HfOₓ), zirconium oxide (ZrOₓ), vanadium oxide (VOₓ) and niobium pentoxide (Nb₂O₅).

10. A method for manufacturing a perovskite solar cell, the method comprising:
step 1 of manufacturing a laminate by forming a perovskite light-absorbing layer on top of a hole transport layer;
step 2 of forming an electron transport layer on top of the perovskite light-absorbing layer through an atomic layer deposition process; and
step 3 of sequentially forming a transparent electrode and a metal electrode on top of the electron transport layer,
wherein the atomic layer deposition process comprises:
step 2-1 of preparing a chamber for an atomic layer deposition process comprising a substrate therein;
step 2-2 of placing a laminate into the chamber for an atomic layer deposition process to position a laminate on top of the substrate;
step 2-3 of injecting an electron transport layer forming material into the chamber for an atomic layer deposition process; and
step 2-4 of performing an atomic layer deposition process to form an electron transport layer on top of the perovskite light-absorbing layer,
wherein Condition (1) below is satisfied:$A > B$ (1)
wherein in Condition (1), A represents a temperature inside the chamber for an atomic layer deposition process, and B represents a temperature of the substrate comprised inside the chamber for an atomic layer deposition process.

11. A method for manufacturing a perovskite solar cell, the method comprising:
step 1 of manufacturing a laminate by sequentially forming a perovskite light-absorbing layer and an interlayer on top of a hole transport layer;
step 2 of forming an electron transport layer on top of the interlayer through an atomic layer deposition process; and
step 3 of sequentially forming a transparent electrode and a metal electrode on top of the electron transport layer,
wherein the atomic layer deposition process comprises:
step 2-1 of preparing a chamber for an atomic layer deposition process comprising a substrate therein;
step 2-2 of placing a laminate into the chamber for an atomic layer deposition process to position a laminate on top of the substrate;
step 2-3 of injecting an electron transport layer forming material into the chamber for an atomic layer deposition process; and
step 2-4 of performing an atomic layer deposition process to form an electron transport layer on top of the interlayer,
wherein Condition (1) below is satisfied: $A > B$ (1)
wherein in Condition (1), A represents a temperature inside the chamber for an atomic layer deposition process, and B represents a temperature of the substrate comprised inside the chamber for an atomic layer deposition process.

12. The method of claim 10 or 11, wherein the atomic layer deposition process of step 2-4 is performed under conditions where a temperature inside the chamber for an atomic layer deposition process is 85 to 150°C and a temperature of the substrate comprised inside the chamber for an atomic layer deposition process is 80°C or less.

13. A method for manufacturing a tandem perovskite solar cell, the method comprising:
step 1 of manufacturing a laminate by sequentially forming a transparent conductive layer, a hole transport layer and a perovskite light-absorbing layer on top of a solar cell;
step 2 of forming an electron transport layer on top of the perovskite light-absorbing layer through an atomic layer deposition process; and
step 3 of sequentially forming a transparent electrode and a metal electrode on top of the electron transport layer,
wherein the atomic layer deposition process comprises:
step 2-1 of preparing a chamber for an atomic layer deposition process comprising a substrate therein;
step 2-2 of placing a laminate into the chamber for an atomic layer deposition process to position a laminate on top of the substrate;
step 2-3 of injecting an electron transport layer forming material into the chamber for an atomic layer deposition process; and
step 2-4 of performing an atomic layer deposition process to form an electron transport layer on top of the perovskite light-absorbing layer,
wherein Condition (1) below is satisfied: $A > B$ (1)
wherein in Condition (1), A represents a temperature inside the chamber for an atomic layer deposition process, and B represents a temperature of the substrate comprised inside the chamber for an atomic layer deposition process.

14. A method for manufacturing a tandem perovskite solar cell, the method comprising:
step 1 of manufacturing a laminate by sequentially forming a transparent conductive layer, a hole transport layer, a perovskite light-absorbing layer and an interlayer on top of a solar cell;
step 2 of forming an electron transport layer on top of the interlayer through an atomic layer deposition process; and
step 3 of sequentially forming a transparent electrode and a metal electrode on top of the electron transport layer,
wherein the atomic layer deposition process comprises:
step 2-1 of preparing a chamber for an atomic layer deposition process comprising a substrate therein;
step 2-2 of placing a laminate into the chamber for an atomic layer deposition process to position a laminate on top of the substrate;
step 2-3 of injecting an electron transport layer forming material into the chamber for an atomic layer deposition process; and
step 2-4 of performing an atomic layer deposition process to form an electron transport layer on top of the interlayer,
wherein Condition (1) below is satisfied: $A > B$ (1)
wherein in Condition (1), A represents a temperature inside the chamber for an atomic layer deposition process, and B represents a temperature of the substrate comprised inside the chamber for an atomic layer deposition process.

15. The method of claim 13 or 14, wherein the atomic layer deposition process of step 2-4 is performed under conditions where a temperature inside the chamber for an atomic layer deposition process is 85 to 150°C and a temperature of the substrate comprised inside the chamber for an atomic layer deposition process is 80°C or less.

16. The method of claim 13 or 14, wherein the solar cell is a polycrystalline silicon solar cell, a crystalline silicon solar cell, a perovskite solar cell, a gallium arsenide (GaAs) solar cell, a cadmium telluride (CdTe) solar cell, a CIGS (CuInGaSe) solar cell, a CZTS (Cu₂ZnSnS₄) solar cell, an organic solar cell, a fuel-sensitized solar cell or a Group 3-5 compound solar cell.
